# EUROPEAN PATENT APPLICATION

(11) **EP 4 712 723 A1**
(43) Date of publication of application: **18.03.2026**
(21) Application number: 25200756.2
(22) Date of filing: 08.09.2025
(51) Int. Cl.: H10D 30/65, H10D 64/00, H10D 64/27, H10D 62/17, H10D 64/23, H10D 62/10

(54) **LDMOS TRANSISTOR**

(30) Priority: 14.09.2024 CN 202411296818
(71) Applicant: Silergy Semiconductor Technology (Hangzhou) Ltd, Hangzhou City, Zhejiang 310051 (CN)
(72) Inventor: YU, Hui, Hangzhou City, 310051 (CN); CAI, Jun, Hangzhou City, 310051 (CN)
(74) Representative: Viering, Jentschura & Partner mbB Patent- und Rechtsanwälte

(57) **Abstract**

An LDMOS transistor is provided. The transistor includes a semiconductor region, source and drain regions of a first doping type disposed in the semiconductor region, a gate dielectric layer adjacent to the source region, a voltage-blocking layer adjacent to the drain region, and a buffer field plate between the gate dielectric layer and the voltage-blocking layer. The gate dielectric layer, the voltage-blocking layer, and the buffer field plate are disposed on an upper surface of the semiconductor region. A thickness of the buffer field plate is less than that of the voltage-blocking layer and greater than that of the gate dielectric layer. The buffer field plate reduces the electric field near a drain side of the gate dielectric layer, thereby shortening the gate dielectric layer's length and decreasing the transistor's turn-on charge, while suppressing tunneling current in the gate dielectric layer during high-voltage operation.

## Description

### FIELD OF THE INVENTION

The present application relates to the field of semiconductor technology, and more particularly, to an LDMOS transistor.

### BACKGROUND OF THE INVENTION.

Laterally Diffused Metal Oxide Semiconductor (LDMOS) transistors are widely used in power integrated circuits as common power devices due to their high breakdown voltage and compatibility with CMOS processes. To reduce power consumption in power stage drivers of high-frequency application terminals, it is preferable to use thin-gate transistors with low threshold voltages. However, when such transistors operate under high voltage conditions, tunneling tends to occur in the thin gate oxide region, which may degrade the device's performance.

### SUMMARY OF THE INVENTION

The present application provides an LDMOS transistor to address the problems existing in the prior art.

A first aspect of the present application provides an LDMOS transistor. The LDMOS transistor includes a semiconductor region, a source region of a first doping type and a drain region of the first doping type both disposed in the semiconductor region, a gate dielectric layer adjacent to the source region, a voltage-blocking layer adjacent to the drain region, and a buffer field plate between the gate dielectric layer and the voltage-blocking layer. The gate dielectric layer, the voltage-blocking layer, and the buffer field plate are disposed on an upper surface of the semiconductor region. A thickness of the voltage-blocking layer is greater than a thickness of the buffer field plate, and the thickness of the buffer field plate is greater than a thickness of the gate dielectric layer.

Preferably, the LDMOS transistor further includes a drift region of the first doping type in the semiconductor region, and the drift region is disposed at least below the voltage-blocking layer.

Preferably, the voltage-blocking layer is formed to protrude inwardly into the semiconductor region.

Preferably, the LDMOS transistor further includes a body region of a second doping type in the semiconductor region, and the body region is formed to extend at least below a portion of the gate dielectric layer.

Preferably, the voltage-blocking layer includes one or a stack of a local silicon oxide layer and a local silicon nitride layer.

Preferably, the thickness of the voltage-blocking layer gradually increases in a direction from the source region toward the drain region.

Preferably, the thickness of the buffer field plate gradually increases in the direction from the source region toward the drain region.

Preferably, a lower surface of the buffer field plate and a lower surface of the gate dielectric layer lie on a same plane, which is parallel to the direction from the source region toward the drain region.

Preferably, the lower surfaces of the buffer field plate and the gate dielectric layer are higher than a lower surface of the voltage-blocking layer.

Preferably, a length of the gate dielectric layer is less than a length of the voltage-blocking layer.

Preferably, a length of the buffer field plate is less than the length of the voltage-blocking layer.

Preferably, the thickness of the gate dielectric layer is 0.95 nm to 9.5 nm.

Preferably, the LDMOS transistor further includes a body contact region of the second doping type adjacent to the source region in the body region, and a source electrode in contact with at least the source region.

Preferably, a junction depth of the body contact region is greater than a junction depth of the source region.

Preferably, the source electrode is formed to extend from an upper surface of the body contact region into an interior of the body contact region.

Preferably, a depth of the source electrode extending into the body contact region is greater than the junction depth of the source region.

Preferably, the body contact region surrounds at least a portion of a lower surface of the source region.

Preferably, the LDMOS transistor further includes a gate conductor disposed at least on the gate dielectric layer.

Preferably, the LDMOS transistor further includes a field shielding conductor disposed at least on the voltage-blocking layer.

Preferably, the LDMOS transistor further includes a reduced surface field region of the second doping type in the semiconductor region, and the reduced surface field region is in mutual depletion with the drift region.

Preferably, the LDMOS transistor further includes a drain electrode formed to extend through the voltage-blocking layer to the drain region located below the voltage-blocking layer.

Preferably, the LDMOS transistor further includes a shallow trench isolation structure located below the voltage-blocking layer.

### BRIEF DESCRIPTION OF DRAWINGS

The above and other objects, features, and advantages of the present application will become more apparent from the following description of the embodiments with reference to the accompanying drawings, in which:
FIG. 1 is a sectional view of an LDMOS transistor according to a first embodiment of the present application;
FIG. 2 is a sectional view of an LDMOS transistor according to a second embodiment of the present application;
FIG. 3 is a sectional view of an LDMOS transistor according to a third embodiment of the present application;
FIG. 4 is a sectional view of an LDMOS transistor according to a fourth embodiment of the present application; and
FIG. 5 is a sectional view of an LDMOS transistor according to a fifth embodiment of the present application.

### DETAILED DESCRIPTION

The present application will be described in further detail below with reference to the accompanying drawings. In the drawings, identical or corresponding elements are designated by like reference numerals. For clarity, the various parts in the drawings are not drawn to scale. In addition, certain well-known components may not be shown. To simplify the illustration, a semiconductor structure obtained after several process steps may be illustrated in a single drawing.

It is to be understood that when a layer or region is described as being "on" or "above" another layer or region, it may be positioned directly on or above the other layer or region, or one or more intervening layers or regions may be present. Furthermore, when the device is inverted, the layer or region may be regarded as being "under" or "below" the other layer or region.

To specifically describe a case where one layer or region is directly on another layer or region, the expression "A is directly on B" or "A is on and adjacent to B" is used herein. In the present application, "A is directly located in B" means that A is positioned within B and is directly adjacent to B, rather than being located within a doped region formed in B.

The following describes many specific details of the present application, such as the device structure, materials, dimensions, processing methods, and techniques, to facilitate a clearer understanding of the present application. However, as understood by those skilled in the art, the present application may be implemented without adhering to these specific details.

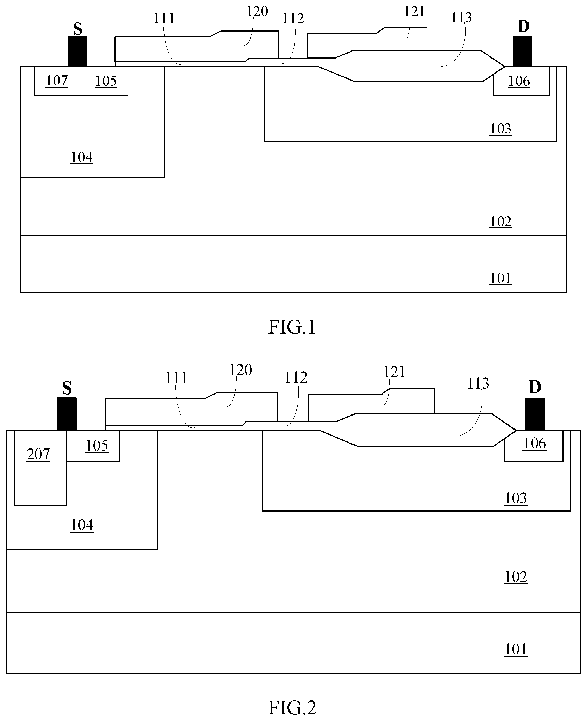

FIG. 1 is a cross-sectional view of an LDMOS transistor according to a first embodiment of the present application. As shown in FIG. 1, the LDMOS transistor includes a semiconductor region 102, a source region 105 of a first doping type and a drain region 106 of the first doping type both disposed in the semiconductor region 102, a gate dielectric layer 111 adjacent to the source region 105, a voltage-blocking layer 113 adjacent to the drain region 106, and a buffer field plate 112 between the gate dielectric layer 111 and the voltage-blocking layer 113. The gate dielectric layer 111, the voltage-blocking layer 113, and the buffer field plate 112 are disposed on an upper surface of the semiconductor region 102. The voltage-blocking layer 113 is formed to protrude inwardly into the semiconductor region 102. A thickness of the voltage-blocking layer 113 is greater than a thickness of the buffer field plate 112, and the thickness of the buffer field plate 112 is greater than a thickness of the gate dielectric layer 111. As a preferred example, a length of the gate dielectric layer 111 is less than a length of the voltage-blocking layer 113, and a length of the buffer field plate 112 is also less than the length of the voltage-blocking layer 113. It should be noted that the length and thickness of the buffer field plate 112, as well as the length and thickness of the voltage-blocking layer 113, may be adjusted as needed based on the requirements of the applied voltage and the ultimate optimization of the specific on-resistance Rsp.

As an example, a lower surface of the voltage-blocking layer 113 is lower than a lower surface of the buffer field plate 112. An upper surface of the buffer field plate 112 is higher than an upper surface of the gate dielectric layer 111, and an upper surface of the voltage-blocking layer 113 is higher than the upper surface of the buffer field plate 112. The lower surface of the buffer field plate 112 and a lower surface of the gate dielectric layer 111 are coplanar or approximately coplanar. It should be noted that when both the gate dielectric layer 111 and the buffer field plate 112 are formed by a dielectric layer deposition process, the lower surfaces of the buffer field plate 112 and the gate dielectric layer 111 are in the same plane (meaning they are flush). When both are formed by a thermal oxidation process, the lower surface of the buffer field plate 112 may be slightly lower than the lower surface of the gate dielectric layer 111.

As an example, the thickness of the buffer field plate 112 is uniform. Alternatively, the thickness of the buffer field plate 112 gradually increases in a direction from the source region toward the drain region.

As an example, the voltage-blocking layer 113 is shaped like a bird's beak and is formed by a local oxidation of silicon process. The thickness of the voltage-blocking layer 113 is uniform except for the bird's beak portion. In other examples, the voltage-blocking layer 113 may also be formed by the dielectric layer deposition process, in which case, the lower surface of the voltage-blocking layer 113 and the lower surface of the buffer field plate 112 are approximately coplanar. Optionally, the thickness of the voltage-blocking layer 113 gradually increases in the direction from the source region toward the drain region.

As an example, the thickness of the gate dielectric layer is set between 0.95 nm and 9.5 nm, which can be formed synchronously with a gate oxide of a CMOS device. The thickness of the buffer field plate is set between 4 nm and 40 nm, and the thickness of the voltage-blocking layer is set between 25 nm and 350 nm. The buffer field plate and the voltage-blocking layer can both be formed by the thermal oxidation or deposition processes.

Specifically, the LDMOS transistor further includes a drift region 103 of the first doping type formed in the semiconductor region 102, a body region 104 of a second doping type formed in the semiconductor region 102, and a body contact region 107 of the second doping type formed in the body region 104 and adjacent to the source region 105. A drain electrode D is disposed on the drain region 106, and a source electrode S is disposed on the source region 105 and the body contact region 107. The drift region 103 is disposed at least below the voltage-blocking layer 113. More specifically, the drift region 103 is formed to extend from the drain region 106 to below the buffer field plate 112. The body region 104 is formed to extend at least below a portion of the gate dielectric layer 111. As an example, a junction depth of the body region 104 is greater than a junction depth of the drift region 103. Furthermore, when the doping types of the semiconductor region and the drift region are the same, the body region and the drift region may be arranged separately or in contact. When the doping types of the semiconductor region and the drift region differ, the body region and the drift region are arranged in contact.

As an example, a junction depth of the source region 105 and a junction depth of the body contact region 107 are the same. In other examples, as shown in FIG. 2, the junction depth of the body contact region 207 is greater than the junction depth of the source region 105. Furthermore, the body contact region surrounds a portion of a lower surface of the source region 105 to reduce the base resistance of a surface parasitic transistor (formed by the source region 105, body region 104, semiconductor region 102, and drift region 103), thereby mitigating the impact of the surface parasitic transistor on the robustness of the LDMOS transistor.

The LDMOS transistor further includes a gate conductor 120 and a field-shielding conductor 121 that are arranged separately. The gate conductor 120 is located at least on the gate dielectric layer 111, and the field-shielding conductor 121 is located at least on the voltage-blocking layer 113. As an example, the gate conductor 120 is disposed on the gate dielectric layer 111 and a portion of the buffer field plate 112. The field-shielding conductor 121 is disposed on a portion of the voltage-blocking layer 113 and a portion of the buffer field plate 112. In an optional embodiment, the gate conductor 120 may be disposed solely on the gate dielectric layer 111, or may extend from the gate dielectric layer 111 onto the buffer field plate 112 or the voltage-blocking layer 113. The field-shielding conductor 121 may be disposed solely on the voltage-blocking layer 113, or may extend from the voltage-blocking layer 113 onto the buffer field plate 112. The gate conductor 120 and the field-shielding conductor 121 are preferably made of polysilicon. The field-shielding conductor 121 may be of the first doping type or the second doping type. The field-shielding conductor 121 can be electrically connected to a same potential as the gate conductor 120, or it may be connected to a different potential independently.

As an example, the LDMOS transistor further includes a substrate 101. The substrate is of the second doping type, and the semiconductor region is of the first doping type. Alternatively, the semiconductor region may also be of the second doping type, at which time the body region and the drift region need to be arranged in contact, meaning that the body region and the drift region physically contact each other without any intervening layer, such as the semiconductor region, being interposed therebetween. Herein, the semiconductor region is configured as a well region or an epitaxial layer. Additionally, other epitaxial layer or a buried layer may be disposed between the substrate and the semiconductor region, which is not limited herein.

The LDMOS transistor provided by the present application features an ultrathin gate dielectric layer 111, resulting in a low threshold voltage for the transistor, which reduces the energy required by low-threshold power modules in driving power integrated circuits and increases the switching frequencies of the low-threshold power modules. Moreover, the reduced threshold voltage increases the reverse surface channel current of the transistor, which in turn suppresses the body reverse recovery current flowing through the well and body regions. Consequently, the power loss in the power stage driver during high-frequency switching is significantly reduced, while the reverse recovery loss of the transistor is also minimized. The buffer field plate 112 can be regarded as an extension of the gate dielectric layer and has a thickness greater than that of the gate dielectric layer, thereby reducing the electric field intensity experienced by the gate dielectric layer near the drain region. This helps shorten the length of the gate dielectric layer, decrease the charge required to turn on the transistor, and suppress the tunneling current in the gate dielectric layer when the transistor operates under high voltage. In addition, the lower surface of the buffer field plate is coplanar with the lower surface of the gate dielectric layer, resulting in a shorter surface current path of the transistor, which can further reduce the transistor's specific on-resistance. The voltage-blocking layer 113 is formed as an oxide layer thicker than the buffer field plate 112 and protrudes inwardly into the semiconductor region, thereby lengthening the surface current path in the transistor's high-voltage region and enhancing its breakdown voltage capability. The voltage-blocking layer 113, together with the field shielding conductor located above it and electrically isolated from the gate electrode, as well as the drift region positioned below, cooperatively enhance the transistor's breakdown voltage, reduce voltage coupling from the drain to the gate stage, lower voltage coupling loss, and effectively decrease the transistor's specific on-resistance.

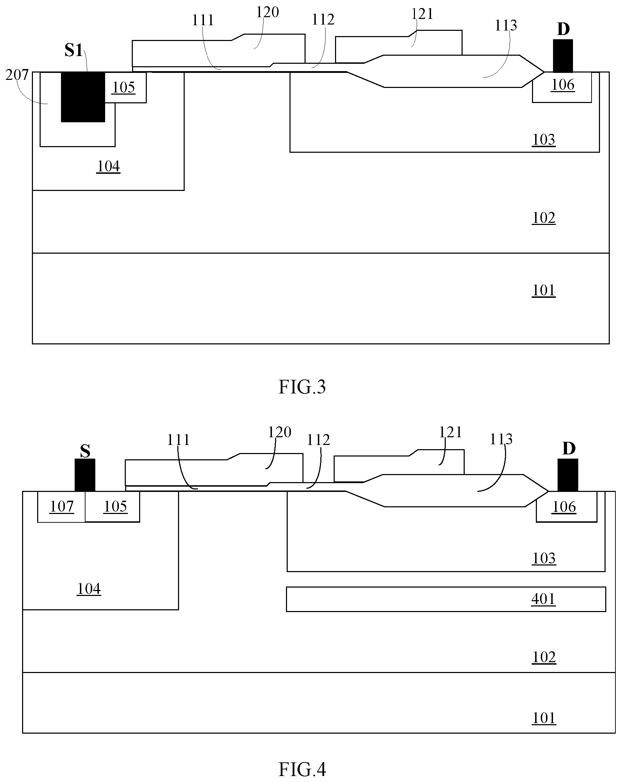

FIG. 3 is a cross-sectional view of an LDMOS transistor according to a third embodiment of the present application. The LDMOS transistors shown in FIGs. 3 and 2 differ in the configuration of the body contact region and the source electrode. Other structural aspects remain substantially the same and will not be described further.

As shown in FIG. 3, the body contact region 207 is formed to extend downward from an upper surface of the body region 104 and laterally to a position below the source region 105, so as to partially surround the lower surface of the source region 105. The source electrode S1 is formed to extend from an upper surface of the body contact region 207 into an interior of the body contact region 207, and is in contact with a side surface of the source region 105. Furthermore, a lower surface of the source electrode S1 is lower than the lower surface of the source region 105. Specifically, the source electrode S1 includes a trench formed in the body contact region 207 and a conductive material filled in the trench.

As an example, the arrangement of the body contact region and the source electrode facilitates the extraction of accumulated charge in the base region of the surface parasitic transistor by the source electrode in the body contact region, thereby enhancing the high-current capability and robustness of the LDMOS transistor, as well as improving its reverse recovery performance.

FIG. 4 is a cross-sectional view of an LDMOS transistor according to a fourth embodiment of the present application. The LDMOS transistor shown in FIG. 4 differs from that shown in FIG. 2 in that it further includes a reduced surface field region of the second doping type. Other structural features are substantially the same.

As an example, the reduced surface field region 401 of the second doping type is disposed below the drift region 103 of the first doping type, the reduced surface field region 401 and the drift region 103 deplete each other to reduce a surface electric field between gate and drain of the transistor and increase the breakdown voltage of the transistor. The reduced surface field region 401 may be arranged in contact with the body region 104, or may be arranged separated from the body region 104. A spacing between the drift region 103 and the reduced surface field region 401 is greater than or equal to zero. Alternatively, the drift region 103 and the reduced surface field region 401 may be arranged side by side, or the reduced surface field region 401 may surround the drift region 103. The positional relationship between the drift region 103 and the reduced surface field region 401 may be adjusted as needed.

As an example, both the drift region 103 and the reduced surface field region 401 are each configured as a single layer. In other examples, the drift region 103 and the reduced surface field region 401 may each include multiple layers.

As another example, the drift region 103 includes multiple separately disposed first doping regions, and the reduced surface field region 401 includes multiple separately disposed second doping regions. Specifically, the multiple separately disposed first doping regions are arranged in a lateral direction, and the multiple separately disposed second doping regions are arranged in a lateral direction, and the second doping regions are located below the first doping regions. Preferably, a corresponding second doping region is disposed below each of the first doping regions. A spacing between adjacent first doping regions and a width of each first doping region can be set arbitrarily as needed. Similarly, a spacing between adjacent second doping regions and a width of each second doping region can also be adjusted as needed.

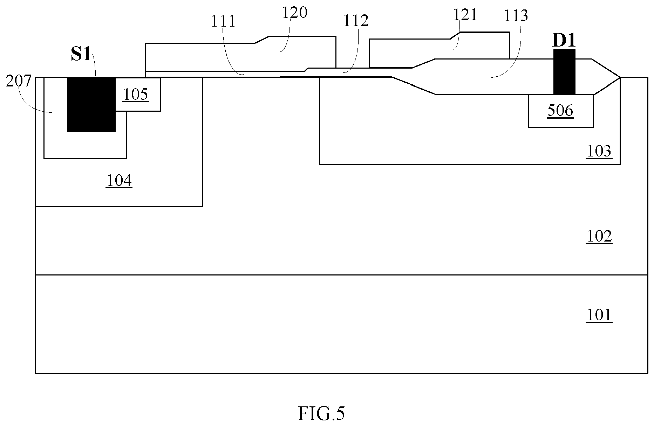

FIG. 5 is a cross-sectional view of an LDMOS transistor according to a fifth embodiment of the present application. The LDMOS transistors shown in FIGs. 5 and 2 differ in the configuration of the drain region. Other structural aspects remain substantially the same and will not be described further.

As an example, the drain region 506 is located below the voltage-blocking layer 113, and the drain electrode D1 extends through the voltage-blocking layer 113 to be in contact with the drain region 506. Preferably, the side edges of the drain region 506 and the voltage-blocking layer 113 are aligned on a side being farther from the buffer field plate 112. Optionally, the LDMOS transistor further includes a shallow isolation trench disposed below the voltage-blocking layer 113. The shallow isolation trench is located between the source region and the drain region.

As an example, the drain region is disposed below the voltage-blocking layer, thereby eliminating the need to form a metal silicide blocking layer in the drain region to reduce the size of the LDMOS transistor.

It should be understood that the foregoing embodiments are provided by way of example only and are not intended to be exhaustive or to limit the present application to the precise forms disclosed. Various modifications and variations may be apparent to those skilled in the art in view of the above disclosure. The embodiments described and illustrated in this specification are selected to better explain the principles and practical applications of the present application, so as to enable those skilled in the art to make full use of the present application and its modifications based on the disclosure of the present application. The scope of the present application is defined solely by the claims and their equivalents.

## Claims

1. An LDMOS transistor, comprising:
a semiconductor region;
a source region of a first doping type and a drain region of the first doping type, both disposed in the semiconductor region;
a gate dielectric layer adjacent to the source region, disposed on an upper surface of the semiconductor region;
a voltage-blocking layer adjacent to the drain region, disposed on the semiconductor region; and
a buffer field plate between the gate dielectric layer and the voltage-blocking layer, disposed on the upper surface of the semiconductor region;
wherein a thickness of the voltage-blocking layer is greater than a thickness of the buffer field plate, and the thickness of the buffer field plate is greater than a thickness of the gate dielectric layer.

2. The LDMOS transistor according to claim 1, further comprising a drift region of the first doping type in the semiconductor region, wherein the drift region is disposed at least below the voltage-blocking layer.

3. The LDMOS transistor according to claim 1, wherein the voltage-blocking layer is formed to protrude inwardly into the semiconductor region.

4. The LDMOS transistor according to claim 1, further comprising a body region of a second doping type in the semiconductor region, wherein the body region is formed to extend at least below a portion of the gate dielectric layer.

5. The LDMOS transistor according to claim 1, wherein the voltage-blocking layer comprises one or a combination of a local silicon oxide layer and a local silicon nitride layer.

6. The LDMOS transistor according to claim 1, wherein the thickness of the voltage-blocking layer gradually increases in a direction from the source region toward the drain region.

7. The LDMOS transistor according to claim 1, wherein the thickness of the buffer field plate gradually increases in a direction from the source region toward the drain region.

8. The LDMOS transistor according to claim 1, wherein a lower surface of the buffer field plate and a lower surface of the gate dielectric layer located on a same plane, which is parallel to a direction from the source region toward the drain region.

9. The LDMOS transistor according to claim 1, wherein lower surfaces of the buffer field plate and the gate dielectric layer are higher than a lower surface of the voltage-blocking layer.

10. The LDMOS transistor according to claim 1, wherein a length of the gate dielectric layer is less than a length of the voltage-blocking layer.

11. The LDMOS transistor according to claim 1, wherein a length of the buffer field plate is less than a length of the voltage-blocking layer.

12. The LDMOS transistor according to claim 1, wherein the thickness of the gate dielectric layer is 0.95 nm to 9.5 nm.

13. The LDMOS transistor according to claim 1, further comprising a gate conductor disposed at least on the gate dielectric layer.

14. The LDMOS transistor according to claim 1, further comprising a field shielding conductor disposed at least on the voltage-blocking layer.

15. The LDMOS transistor according to claim 1, further comprising a drain electrode formed to extend through the voltage-blocking layer to the drain region located below the voltage-blocking layer.
